# EUROPEAN PATENT APPLICATION

(11) **EP 4 835 576 A1**
(43) Date of publication of application: **04.11.2026**
(21) Application number: 24912670.7
(22) Date of filing: 20.12.2024
(51) Int. Cl.: G03F 7/11, C08G 63/00, G03F 7/20

(54) **COMPOSITION FOR FORMING RESIST UNDERLAYER FILM**

(30) Priority: 27.12.2023 JP 2023220589
(71) Applicant: Nissan Chemical Corporation, Tokyo 103-6119 (JP)
(72) Inventor: TANAKA Takumi, Toyama-shi, Toyama 939-2792 (JP); NISHITA Tokio, Toyama-shi, Toyama 939-2792 (JP); ENDO Yuki, Toyama-shi, Toyama 939-2792 (JP)
(74) Representative: Hoffmann Eitle
(86) International application number: PCT/JP2024/045192
(87) International publication number: WO 2025/142781

(57) **Abstract**

A resist underlayer film-forming composition, containing a polymer having a unit structure represented by the following Formula (1) and a solvent: 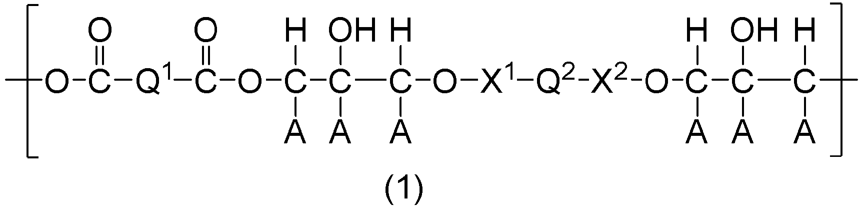 wherein, in Formula (1), A's each independently represent a hydrogen atom, a methyl group, or an ethyl group, Q¹ and Q² each independently represent a divalent group having an aromatic hydrocarbon ring, and X¹ and X² each independently represent a single bond or -C(=O)-.

## Description

### Technical Field

The present invention relates to a resist underlayer film-forming composition, a resist underlayer film, a laminate, a semiconductor element producing method, and a pattern forming method.

### Background Art

In the related art, a lithography process using a resist composition has been performed in the production of semiconductor devices. The degree of integration of semiconductor devices is increased, and thus there is a need to miniaturize patterns of wiring or the like. Short-wavelength light such as a KrF excimer laser (wavelength: 248 nm) or an ArF excimer laser (wavelength: 193 nm) has been adopted for miniaturization of patterns. When such short-wavelength light is used, the influence of diffuse reflection from the substrate and standing waves becomes a major problem. Then, a method for providing a bottom anti reflective coating between a resist film and a substrate has been widely adopted.

In general, it is effective to increase the refractive index of the bottom anti reflective coating for antireflection.

Therefore, in order to obtain a resist underlayer film having a high n value (refractive index), a resist underlayer film-forming composition for lithography containing a polymer having a disulfide bond in the main chain and a solvent has been proposed (see Patent Literature 1).

### Citation List

### Patent Literature

Patent Literature 1: WO 2009/096340 A

### Summary of Invention

### Technical Problem

In the technique described in Patent Literature 1, a resist underlayer film having a high refractive index of about 1.9 is obtained.

Incidentally, with the diversification of semiconductor devices, lithography processes are also diversified. In this regard, the refractive index of the resist underlayer film is not necessarily high, and the required refractive index is also different depending on the lithography process, and a resist underlayer film having a relatively low refractive index may be required.

An object of the present invention is to provide a resist underlayer film-forming composition capable of obtaining a resist underlayer film having a relatively low refractive index, a resist underlayer film formed using the resist underlayer film-forming composition, a laminate, a semiconductor element producing method, and a pattern forming method, for all of which the resist underlayer film-forming composition is used.

### Solution to Problem

As a result of intensive studies to solve the above problem, the present inventors have found that the above problem can be solved, and completed the present invention having the following gist.

That is, the present invention includes the following items.
[1] A resist underlayer film-forming composition, containing: a polymer having a unit structure represented by the following Formula (1); and a solvent: 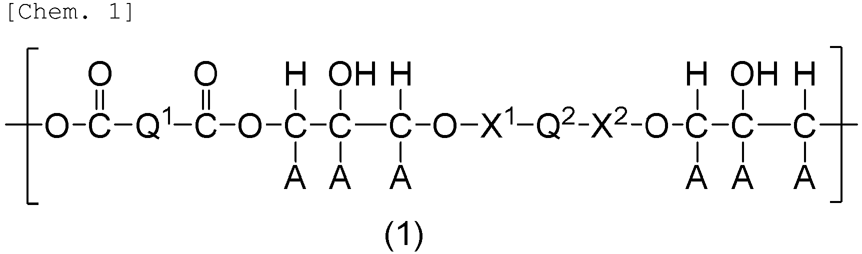 wherein, in Formula (1), A's each independently represent a hydrogen atom, a methyl group, or an ethyl group, Q¹ and Q² each independently represent a divalent group having an aromatic hydrocarbon ring, and X¹ and X² each independently represent a single bond or -C(=O)-.
[2] The resist underlayer film-forming composition according to [1], wherein, in the above Formula (1), Q¹ is represented by the following Formula (2), and Q² is represented by any one of the following Formulae (3-1) to (3-3): 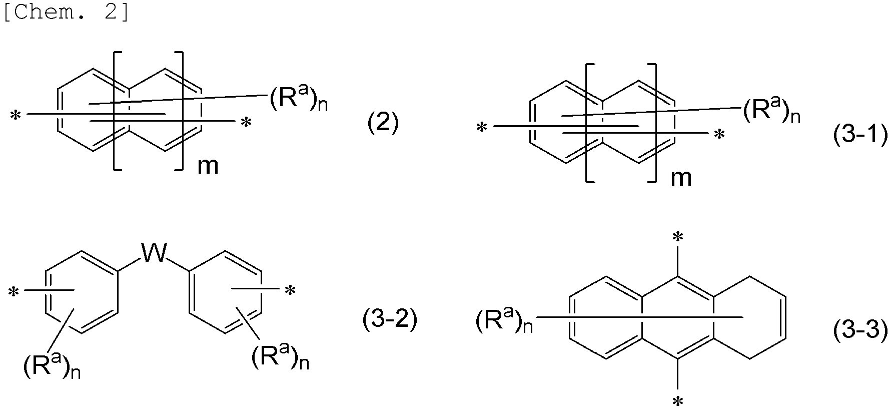
   wherein, in Formula (2) and Formulae (3-1) to (3-3), R^{a}'s each independently represent an alkyl group having 1 to 10 carbon atoms, an alkoxy group having 1 to 10 carbon atoms, or an alkenyl group having 2 to 10 carbon atoms,
   W represents a single bond, -CH₂-, -C(CH₃)₂-, -C(CF₃)₂-, -CO-, -O-, -S-, or SO₂-,
   m's each independently represent an integer of 0 to 2,
   n's each independently represent an integer of 0 to 4, and
   * represents a bonding site.
[3] The resist underlayer film-forming composition according to [1] or [2], wherein the solvent contains at least one type selected from the group consisting of an alkylene glycol monoalkyl ether and a monocarboxylic acid ester of an alkylene glycol monoalkyl ether.
[4] The resist underlayer film-forming composition according to any one of [1] to [3], further containing a crosslinking agent.
[5] The resist underlayer film-forming composition according to any one of [1] to [4], further containing a curing catalyst.
[6] A resist underlayer film, which is a cured product of the resist underlayer film-forming composition according to any one of [1] to [5].
[7] A laminate, including:
   a semiconductor substrate; and
   the resist underlayer film according to [6].
[8] A semiconductor element producing method, including steps of:
   forming a resist underlayer film on a semiconductor substrate using the resist underlayer film-forming composition according to any one of [1] to [5]; and
   forming a resist film on the resist underlayer film.
[9] A pattern forming method, including steps of:
   forming a resist underlayer film on a semiconductor substrate using the resist underlayer film-forming composition according to any one of [1] to [5];
   forming a resist film on the resist underlayer film;
   irradiating the resist film with light, and then developing the resist film to obtain a resist pattern; and
   etching the resist underlayer film using the resist pattern as a mask.

### Advantageous Effects of Invention

According to the present invention, it is possible to provide a resist underlayer film-forming composition capable of obtaining a resist underlayer film having a relatively low refractive index, a resist underlayer film formed using the resist underlayer film-forming composition, a laminate, a semiconductor element producing method, and a pattern forming method, for all of which the resist underlayer film-forming composition is used.

### Description of Embodiments

### (Resist Underlayer Film-Forming Composition)

A resist underlayer film-forming composition of the present invention contains a polymer (hereinafter, referred to as a polymer (A) in some cases) and a solvent (hereinafter, referred to as a solvent (B) in some cases).

The resist underlayer film-forming composition may contain a crosslinking agent (hereinafter, referred to as a crosslinking agent (C) in some cases), a curing catalyst (hereinafter, referred to as a curing catalyst (D) in some cases), and the like.

### <Polymer (A)>

The polymer (A) has a unit structure represented by the following Formula (1). 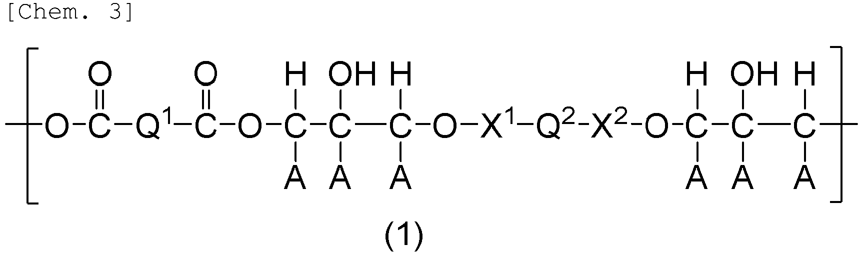 wherein, in Formula (1), A's each independently represent a hydrogen atom, a methyl group, or an ethyl group, Q¹ and Q² each independently represent a divalent group having an aromatic hydrocarbon ring, and X¹ and X² each independently represent a single bond or -C(=O)-.

When the polymer (A) contained in the resist underlayer film-forming composition has the unit structure represented by Formula (1), the refractive index of the resist underlayer film obtained from the resist underlayer film-forming composition can be reduced by the aromatic hydrocarbon ring in Q¹ and Q².

The number of carbon atoms in Q¹ and Q² is not particularly limited, and may be, for example, 6 to 30 or 6 to 20.

Q¹ in Formula (1) is preferably represented by the following Formula (2) from the viewpoint of suitably obtaining the effects of the present invention.

Q² in Formula (1) is preferably represented by any one of the following Formulae (3-1) to (3-3) from the viewpoint of suitably obtaining the effects of the present invention. 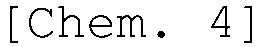 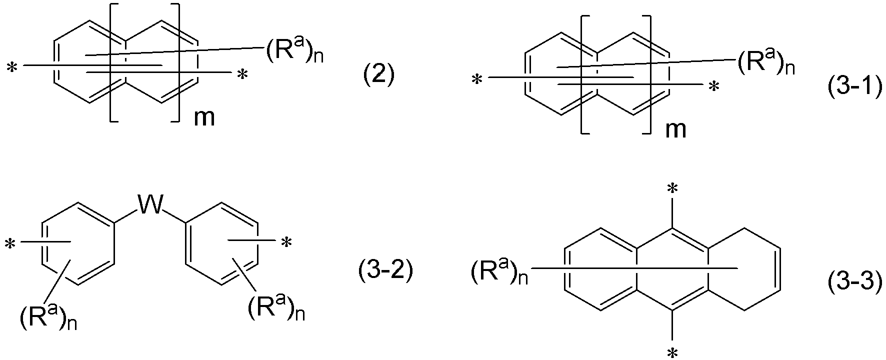
wherein, in Formula (2) and Formulae (3-1) to (3-3), R^{a}'s each independently represent an alkyl group having 1 to 10 carbon atoms, an alkoxy group having 1 to 10 carbon atoms, or an alkenyl group having 2 to 10 carbon atoms,
W represents a single bond, -CH₂-, -C(CH₃)₂-, -C(CF₃)₂-, -CO-, -O-, -S-, or SO₂-,
m's each independently represent an integer of 0 to 2,
n's each independently represent an integer of 0 to 4, and
* represents a bonding site.

Examples of the alkyl group having 1 to 10 carbon atoms include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

Examples of the alkoxy group having 1 to 10 carbon atoms include a methoxy group, an ethoxy group, a n-propoxy group, an i-propoxy group, a n-butoxy group, an i-butoxy group, a s-butoxy group, a t-butoxy group, a n-pentyloxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, a n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, a 1-ethyl-2-methyl-n-propoxy group, a cyclopentyloxy group, a cyclohexyloxy group, a norbornyloxy group, and an adamantyloxy group.

Examples of the alkenyl group having 2 to 10 carbon atoms include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl group, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group.
m in Formula (2) is preferably 0 or 1, and more preferably 0 from the viewpoint of more suitably obtaining the effects of the present invention.
m in Formula (3-1) is preferably 0 or 1 from the viewpoint of more suitably obtaining the effects of the present invention.

From the viewpoint of more suitably obtaining the effects of the present invention, n's in Formula (2) and Formulae (3-1) to (3-3) are each independently preferably an integer of 0 to 2, more preferably 0 or 1, and particularly preferably 0.

R^{a} is preferably an alkyl group having 1 to 4 carbon atoms or an alkoxy group having 1 to 4 carbon atoms.

Examples of the structure represented by the following Formula (1-a) in Formula (1) include structures exemplified below. 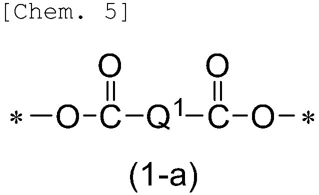 wherein, in Formula (1-a), Q¹ has the same meaning as Q¹ in Formula (1), and * represents a bonding site. 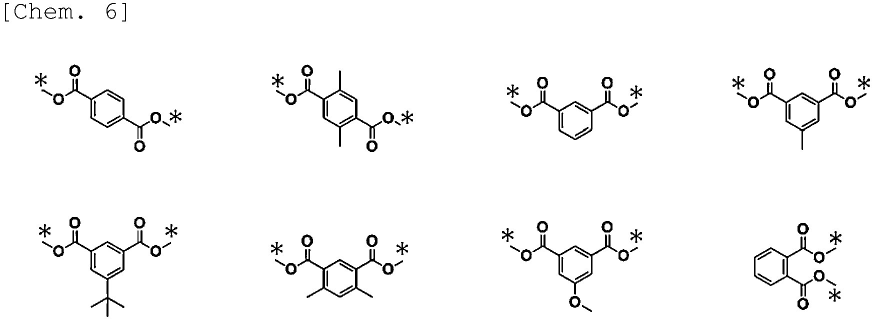 * represents a bonding site.

Examples of the structure represented by the following Formula (1-b) in Formula (1) include structures exemplified below. 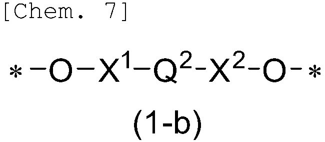 wherein, in Formula (1-b), Q², X¹, and X² have the same meanings as Q², X¹, and X² in Formula (1), respectively, and * represents a bonding site. 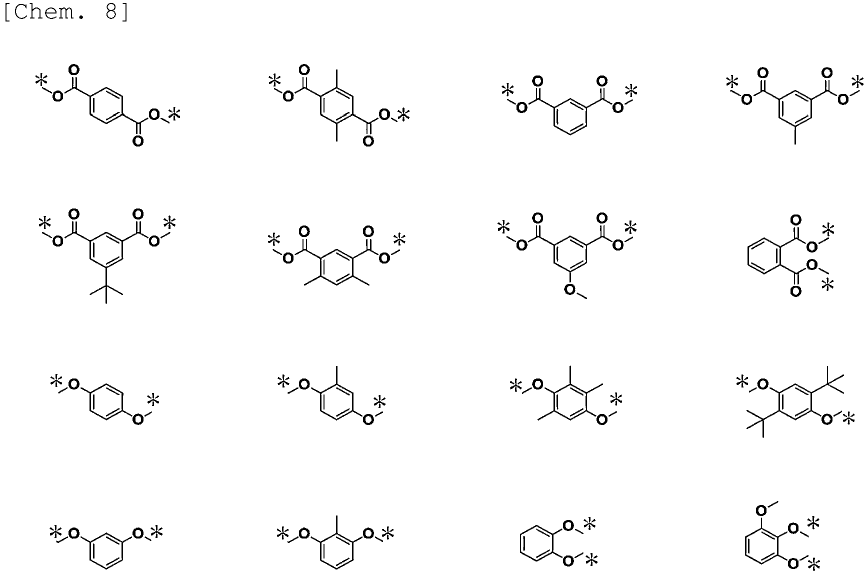 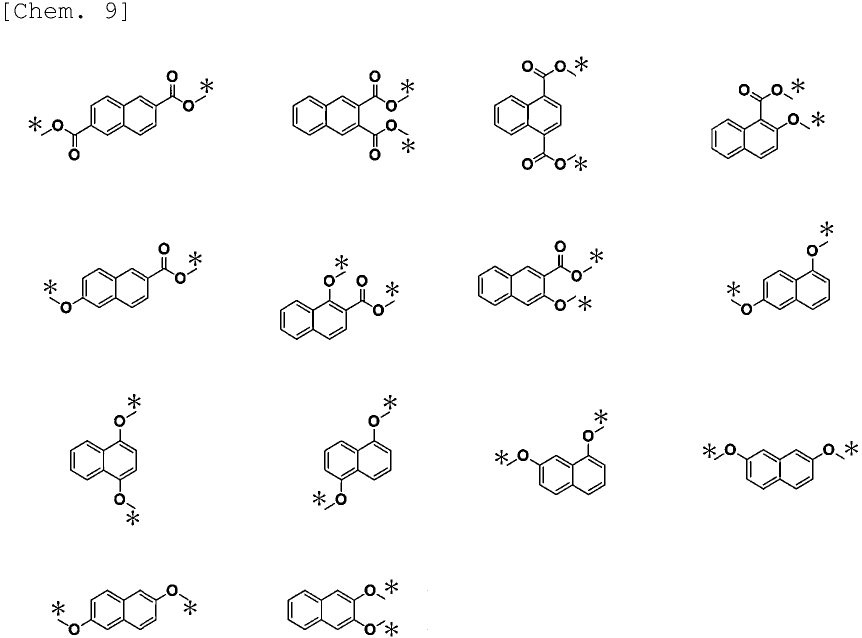 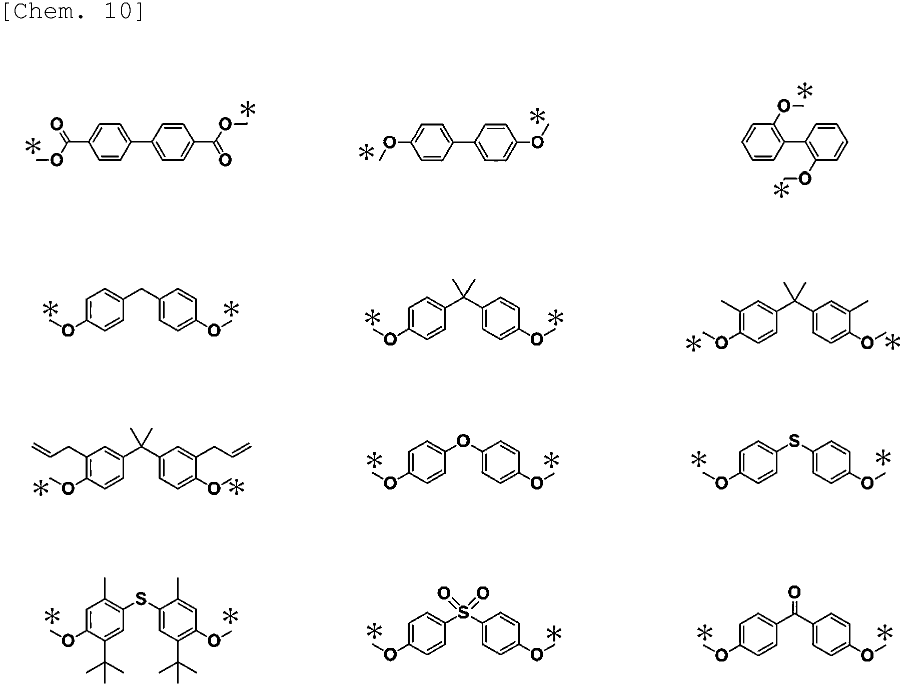 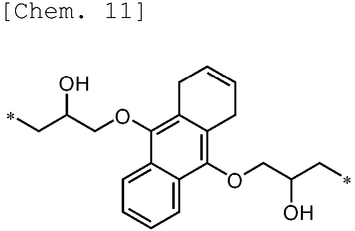 * represents a bonding site.

The polymer may further have a monovalent group represented by the following Formula (E). The monovalent represented by Formula (E) is, for example, located at the end of the polymer. 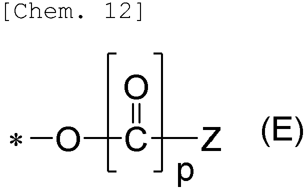 wherein, in Formula (E), p represents 0 or 1, Z represents a monovalent group having 1 to 20 carbon atoms, and * represents a bonding site.

The number of carbon atoms in Z is preferably 6 to 20.

Z has, for example, an aromatic hydrocarbon ring. Examples of the aromatic hydrocarbon ring include a benzene ring, a naphthalene ring, and an anthracene ring.

For example, in Formula (E), Z has an aromatic hydrocarbon ring, and the carbon atom constituting the aromatic hydrocarbon ring is bonded to the carbonyl carbon atom in Formula (E).

Examples of Z in Formula (E) include a group represented by the following Formula (E-1). 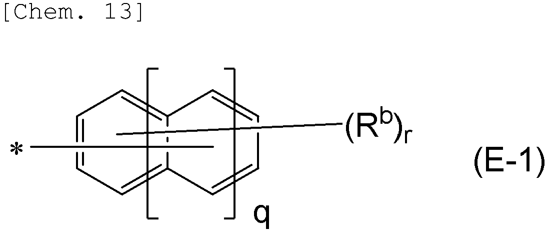 wherein, in Formula (E-1), q represents an integer of 0 to 2, r represents an integer of 0 to 4, R^{b}'s each independently represent a halogen atom, a hydroxy group, an alkyl group having 1 to 6 carbon atoms, or an alkoxy group having 1 to 6 carbon atoms, and * represents a bonding site.

Examples of the monovalent group represented by Formula (E) include the following groups. 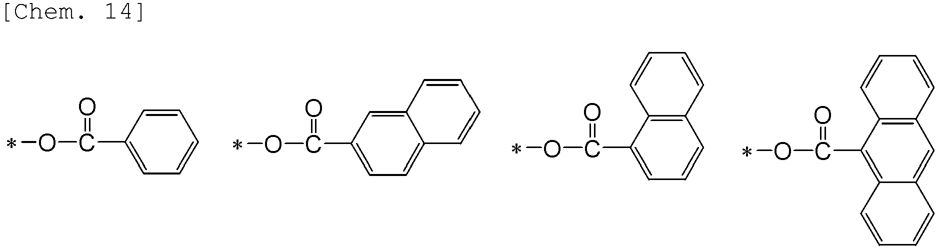 * represents a bonding site.

The polymer having a unit structure represented by Formula (1) can be synthesized, for example, by the following method.
(I): A reaction between a compound represented by the following (1A) and a compound represented by the following Formula (1B).
(II): A reaction between a compound represented by the following (1A), a compound represented by the following Formula (1B), and a compound represented by the following Formula (EA).

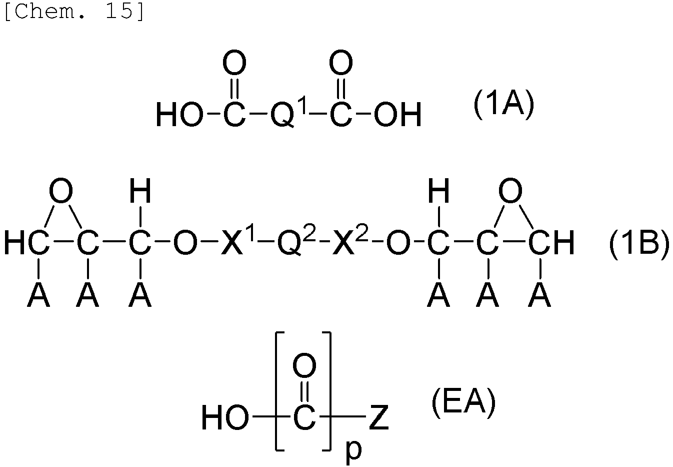

wherein, in Formula (1A), Q¹ has the same meaning as Q¹ in Formula (1),
in Formula (1B), A, Q², X¹, and X² have the same meanings as A, Q², X¹, and X² in Formula (1), respectively, and
in Formula (EA), p and Z have the same meanings as p and Z in Formula (E), respectively.

The reaction may be performed, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected and used from a range of 0.1 to 10 mass% with respect to the total mass of a reaction raw material used in the reaction. As the temperature and time for the reaction, for example, optimum conditions can be selected from a range of 50 to 160°C and a range of 2 to 50 hours.

The mass ratio of the unit structure represented by Formula (1) in the polymer (A) is not particularly limited, but is preferably 50 mass% or more, more preferably 60 mass% or more, and particularly preferably 80 mass% or more.

The weight average molecular weight of the polymer (A) is not particularly limited, but is preferably 1,000 to 30,000, more preferably 2,000 to 20,000, and particularly preferably 2,500 to 15,000.

The content of the polymer (A) in the resist underlayer film-forming composition is not particularly limited, but from the viewpoint of suitably obtaining the effects of the present invention, the content is preferably 40 mass% to 100 mass%, more preferably 50 mass% to 98 mass%, and particularly preferably 65 mass% to 95 mass% relative to the film constituent components.

In the present invention, the film constituent component means a component other than the solvent contained in the composition.

### <Solvent (B)>

The solvent (B) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (B), an alkylene glycol monoalkyl ether and a monocarboxylic acid ester of an alkylene glycol monoalkyl ether are preferable.

One type of these solvents (B) can be used singly or two or more types thereof can be used in combination.

The mass ratio of the organic solvent in the solvent (B) is not particularly limited, and is preferably 50 mass% to 100 mass%.

The content of the solvent (B) in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking Agent (C)>

The crosslinking agent (C) is not particularly limited.

The crosslinking agent (C) has a structure different from that of the polymer (A).

As the crosslinking agent (C), an aminoplast crosslinking agent and a phenoplast crosslinking agent are preferable.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below.

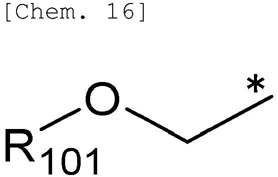

In the structure, R₁₀₁ represents a hydrogen atom, an alkyl group having 1 to 4 carbon atoms, or an alkoxyalkyl group having 2 to 6 carbon atoms, and * represents a bonding site.

The bond is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferable. 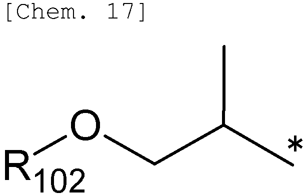 wherein, in the structure, R₁₀₂ represents a methyl group or an ethyl group, and * represents a bonding site.

The crosslinking agent (C) is preferably a melamine compound, a guanamine compound, a glycoluril compound, a urea compound, or a compound having a phenolic hydroxy group. These compounds can be used singly or in combination with two or more kinds thereof.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethyl glycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by the following Formula (1E). 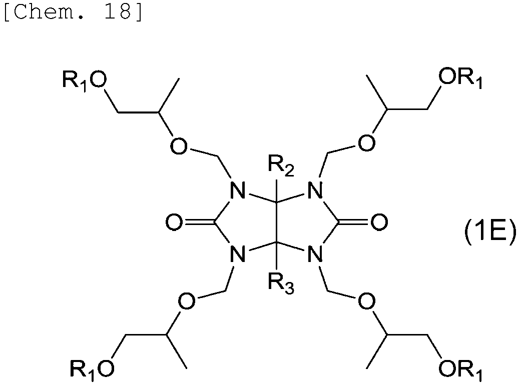 wherein, in Formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by the above Formula (1E) include compounds represented by the following Formulae (1E-1) to (1E-6).

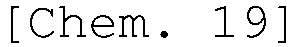

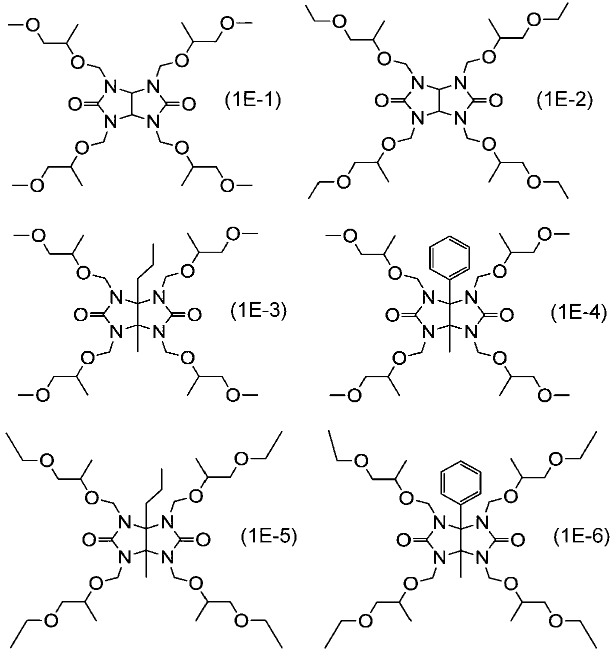

The glycoluril derivative represented by Formula (1E) is obtained by, for example, reacting a glycoluril derivative represented by the following Formula (2E) with at least one type of compound represented by the following Formula (3d). 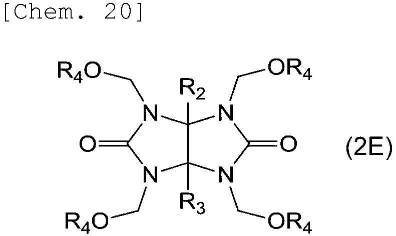 wherein, in Formula (2E), R₂ and R₃ each independently represent a hydrogen atom, an alkyl group having 1 to 4 carbon atoms, or a phenyl group, and R₄'s each independently represent an alkyl group having 1 to 4 carbon atoms. 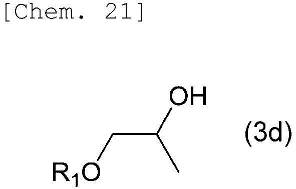 wherein, in Formula (3d), R₁ represents a methyl group or an ethyl group.

Examples of the glycoluril derivative represented by the above Formula (2E) include compounds represented by the following Formulae (2E-1) to (2E-4). Further, examples of the compound represented by the above Formula (3d) include compounds represented by the following Formulae (3d-1) and (3d-2).

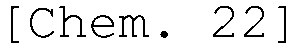

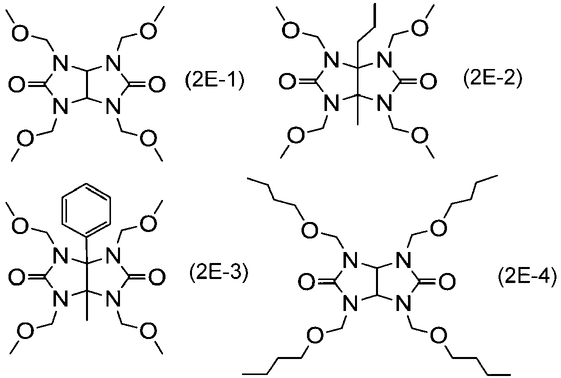

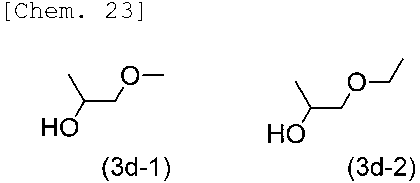

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by the following Formula (G-1) or (G-2). 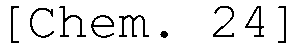 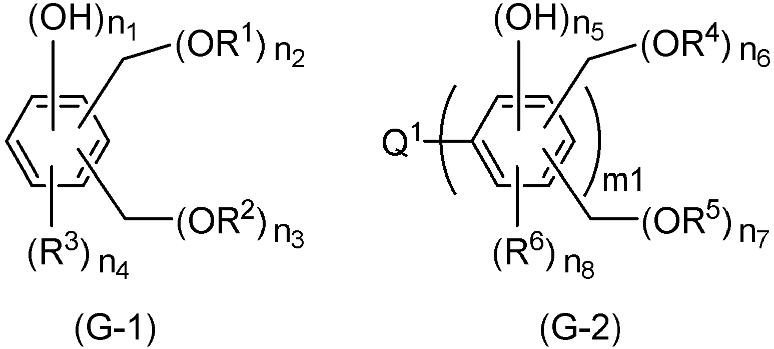
wherein, in Formulae (G-1) and (G-2), Q¹ represents a single bond or an m1-valent organic group,
R¹ and R⁴ each represent an alkyl group having 2 to 10 carbon atoms or an alkyl group having 2 to 10 carbon atoms and having an alkoxy group having 1 to 10 carbon atoms,
R² and R⁵ each represent a hydrogen atom or a methyl group,
R³ and R⁶ each represent an alkyl group having 1 to 10 carbon atoms or an aryl group having 6 to 40 carbon atoms,
n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6,
n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and an integer that meets 2 ≤ (n₅ + n₆ + n₇ + n₈) ≤ 5, and
m1 represents an integer of 2 to 10.

Examples of the compound having a phenolic hydroxy group include a compound represented by the following Formula (G-3) or (G-4).

The compound represented by Formula (G-1) or (G-2) may be obtained by a reaction of a compound represented by the following Formula (G-3) or (G-4) with a hydroxyl group-containing ether compound or an alcohol having 2 to 10 carbon atoms. 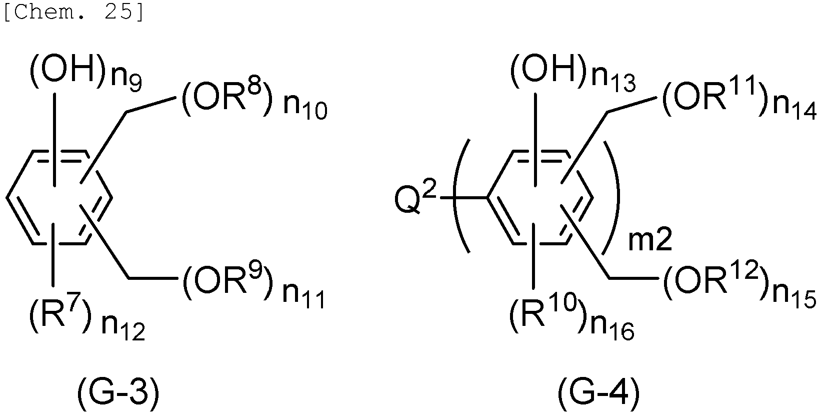
wherein, in Formulae (G-3) and (G-4), Q² represents a single bond or an m2-valent organic group,
R⁸, R⁹, R¹¹, and R¹² each represent a hydrogen atom or a methyl group,
R⁷ and R¹⁰ each represent an alkyl group having 1 to 10 carbon atoms or an aryl group having 6 to 40 carbon atoms,
n₉ represents an integer that satisfies 1 ≤ n₉ ≤ 3, n₁₀ represents an integer that satisfies 2 ≤ n₁₀ ≤ 5, n₁₁ represents an integer that satisfies 0 ≤ n₁₁ ≤ 3, n₁₂ represents an integer that satisfies 0 ≤ n₁₂ ≤ 3, and an integer that satisfies 3 ≤ (n₉ + n₁₀ + n₁₁ + n₁₂) ≤ 6,
n₁₃ represents an integer that satisfies 1 ≤ n₁₃ ≤ 3, n₁₄ represents an integer that satisfies 1 ≤ n₁₄ ≤ 4, n₁₅ represents an integer that satisfies 0 ≤ n₁₅ ≤ 3, and n₁₆ represents an integer that satisfies 0 ≤ n₁₆ ≤ 3, and an integer that satisfies 2 ≤ (n₁₃ + n₁₄ + n₁₅ + n₁₆) ≤ 5, and
m2 represents an integer of 2 to 10.

Examples of the m2-valent organic group of Q² include an m2-valent organic group having 1 to 4 carbon atoms.

Examples of the compound represented by Formula (G-1) or (G-2) include the following compounds.

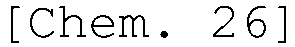

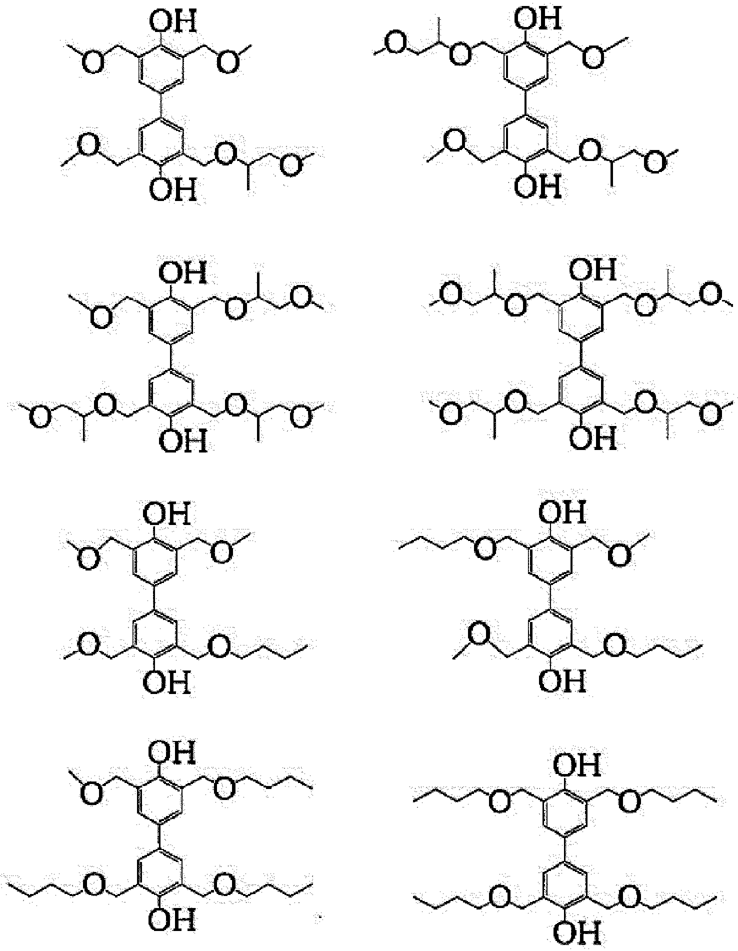

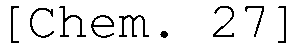

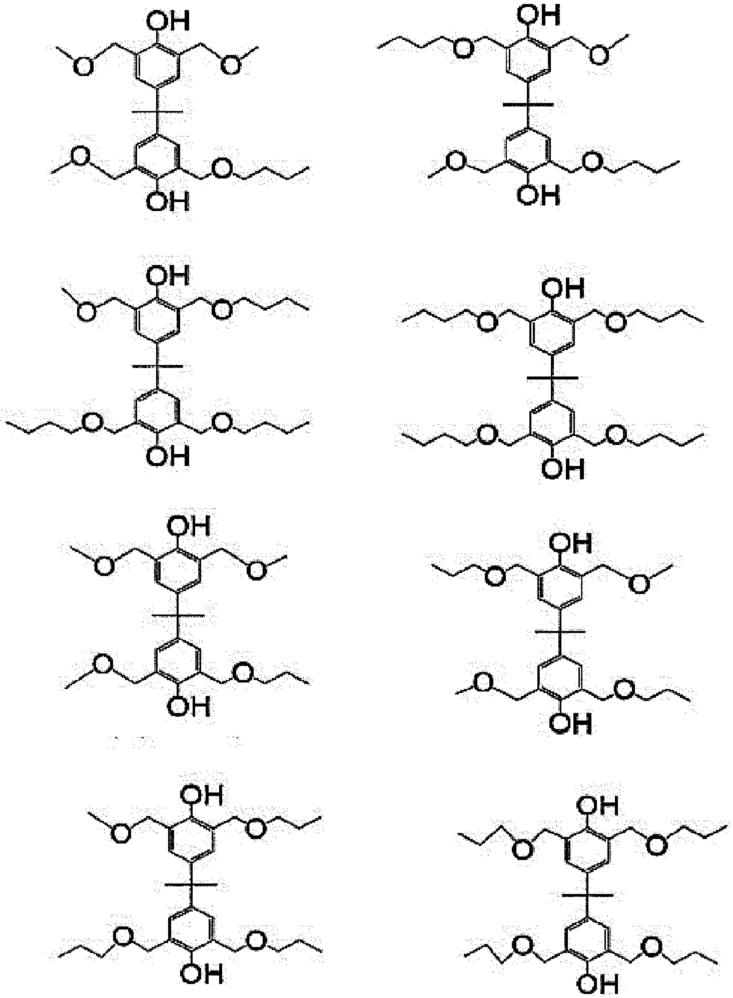

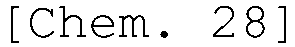

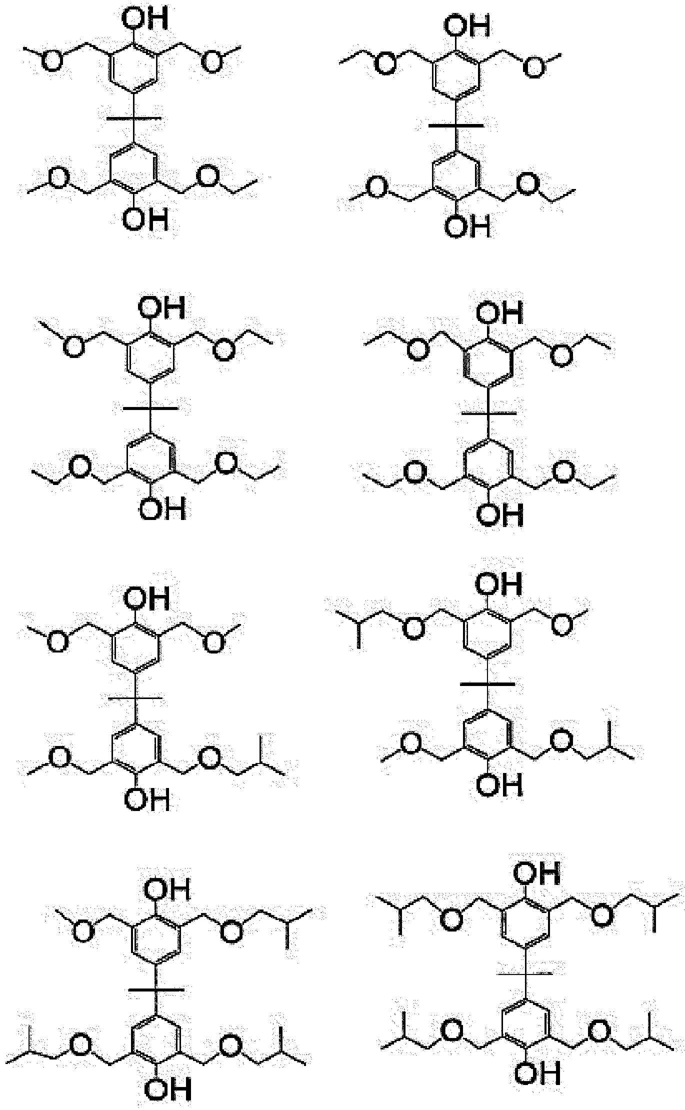

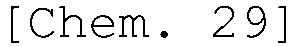

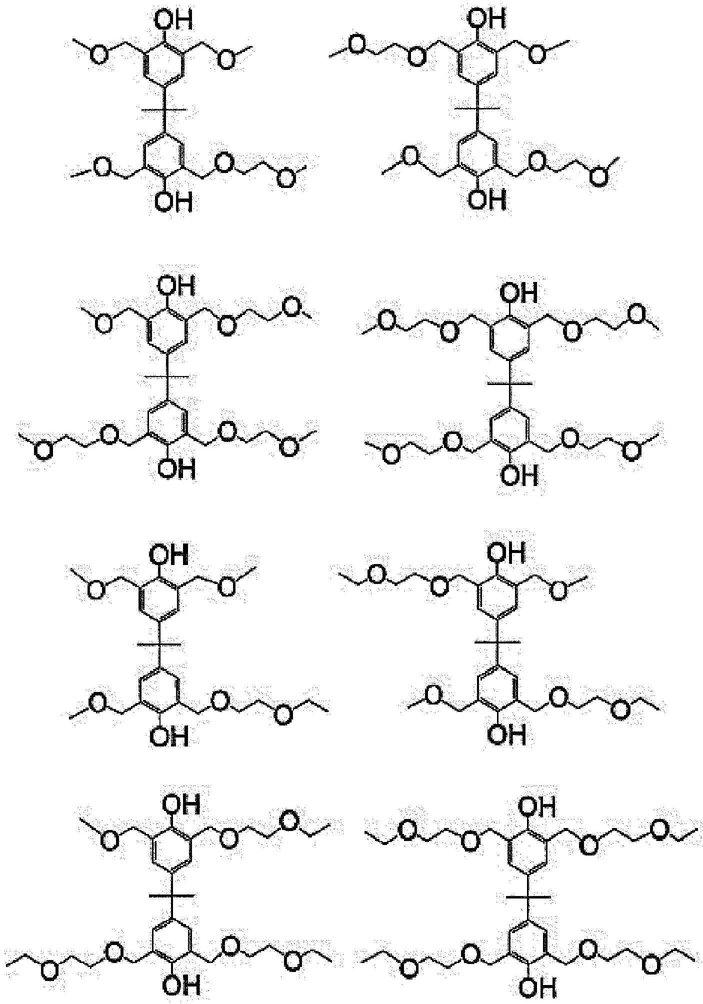

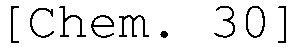

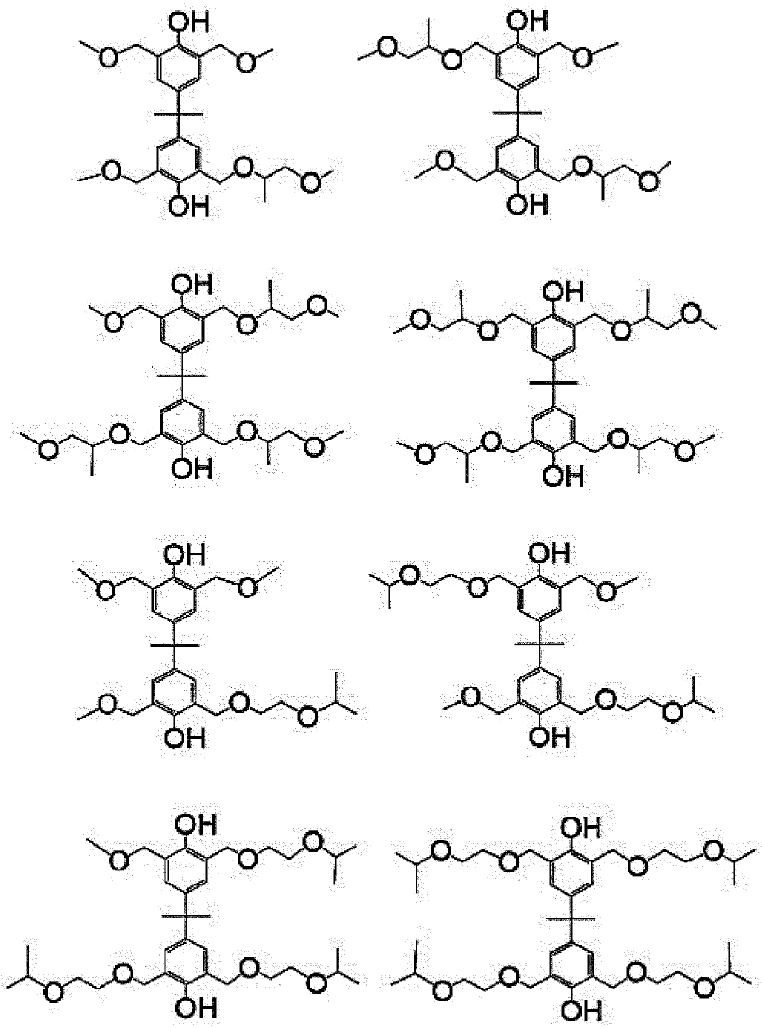

Examples of the compound represented by Formula (G-3) or (G-4) include the following compounds.

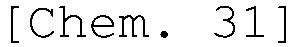

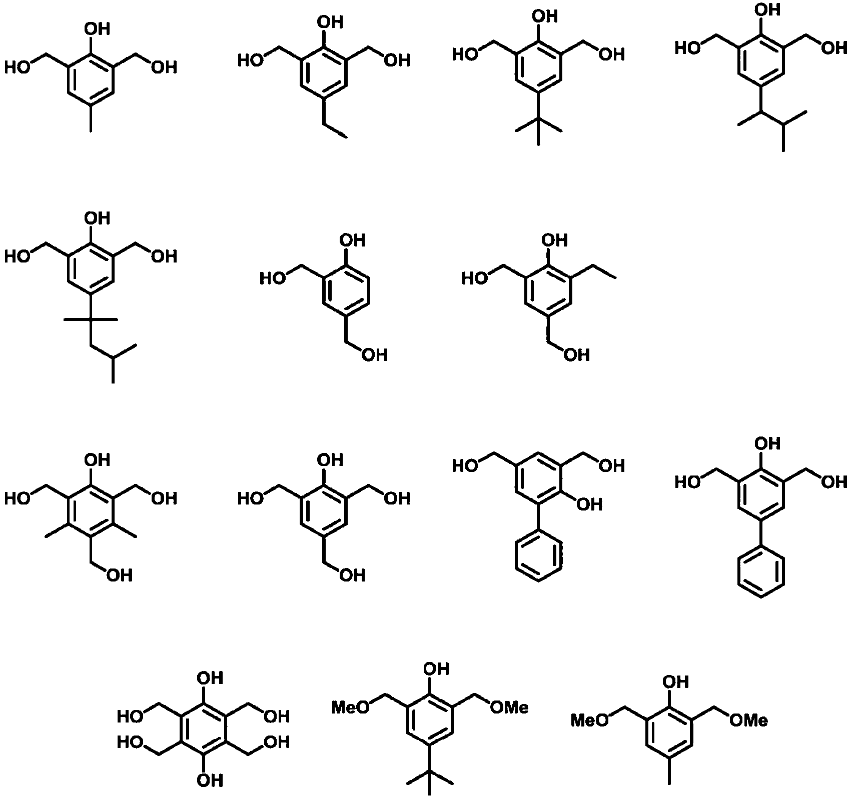

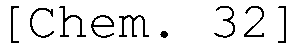

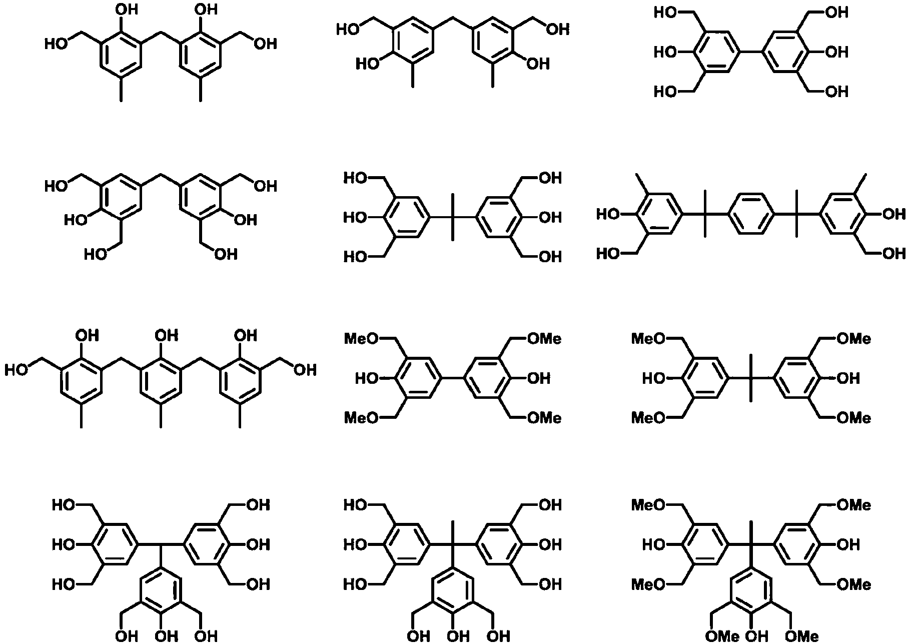

The compounds can be obtained as products of Asahi Organic Chemicals Industry Co., Ltd. and Honshu Chemical Industry Co., Ltd. Examples of the product include TMOM-BP (trade name) manufactured by Asahi Yukizai Corporation.

Among the compounds, the glycoluril compound is preferable. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferable, and tetramethoxymethyl glycoluril is more preferable.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the polymer (A).

### <Curing Catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate, and the like.

Examples of the sulfonimide compound include N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, methylsulfonyl-p-toluenesulfonyl diazomethane, and the like.

As the curing catalyst (D), only one type can be used, or two or more types can be used in combination.

In a case where the curing catalyst (D) is used, the content ratio of the curing catalyst (D) is, for example, 0.1 mass% to 50 mass%, and preferably 1 mass% to 30 mass% with respect to the crosslinking agent (C).

### <Other Components>

To the resist underlayer film-forming composition, a surfactant can be further added in order to further improve the coatability against surface unevenness without generating a pinhole, a striation, and the like.

Examples of the surfactant include linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonionic surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by AGC Corporation, trade names); and organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The amount of the solid content in the resist underlayer film-forming composition of the present invention, that is, the amount of the components excluding the solvent is, for example, 0.01 mass% to 10 mass%.

### (Resist Underlayer Film)

The resist underlayer film of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using the semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass, SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Thereafter, baking is performed using a heating unit such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The refractive index (n value) of the resist underlayer film at a wavelength of 193 nm is not particularly limited, and may be, for example, 1.30 to 1.50 or 1.30 to 1.45.

The attenuation coefficient (k value) of the resist underlayer film at a wavelength of 193 nm is not particularly limited, and may be, for example, 0.23 to 0.50 or 0.25 to 0.45.

These optical constants can be measured, for example, by the following method. That is, an n value (refractive index) and a k value (attenuation coefficient or extinction coefficient) at a wavelength of 193 nm of the film are measured using a spectroscopic ellipsometer (product name: VUV-VASE VU-302, manufactured by J.A. Woollam).

The film can be formed, for example, by applying a composition to be tested onto a silicon wafer at a rotation speed of 1500 rpm with a spinner and baking the composition on a hot plate at 205°C for 1 minute.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

### (Laminate)

A laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Semiconductor Element Producing Method and Pattern Forming Method)

The semiconductor element producing method of the present invention includes at least the following steps.
· a step of forming a resist underlayer film on a semiconductor substrate using the resist underlayer film-forming composition of the present invention, and
· a step of forming a resist film on the resist underlayer film.

The pattern forming method of the present invention includes at least the following steps.
· a step of forming a resist underlayer film on a semiconductor substrate using the resist underlayer film-forming composition of the present invention;
· a step of forming a resist film on the resist underlayer film;
· a step of irradiating the resist film with light, and then developing the resist film to obtain a resist pattern; and
· a step of etching the resist underlayer film using the resist pattern as a mask.

The resist film is usually formed on the resist underlayer film.

The film thickness of the resist film is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (for example, application and baking of a resist composition) is not particularly limited as long as it responds to light used for irradiation. Both a negative photoresist and a positive photoresist can be used.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

So-called resist compositions such as resist compositions, radiation-sensitive resin compositions, high-resolution patterning compositions based on organometallic solutions, and metal-containing resist compositions, which are disclosed in WO2019/188595 A, WO2019/187881 A, WO2019/187803 A, WO2019/167737 A, WO2019/167725 A, WO2019/187445 A, WO2019/167419 A, WO2019/123842 A, WO2019/054282 A, WO2019/058945 A, WO2019/058890 A, WO2019/039290 A, WO2019/044259 A, WO2019/044231 A, WO2019/026549 A, WO2018/193954 A, WO2019/172054 A, WO2019/021975 A, WO2018/230334 A, WO2018/194123 A, JP 2018-180525 A, WO2018/190088 A, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896 A, JP 2019-113855 A, WO2017/156388 A, WO2017/066319 A, JP 2018-41099 A, WO2016/065120 A, WO2015/026482 A, JP 2016-29498 A, and JP 2011-253185 A, can be used, but are not limited to these.

Examples of the resist composition include the following compositions.

An actinic ray-sensitive or radiation-sensitive resin composition containing a resin A having a repeating unit having an acid-decomposable group in which a polar group is protected by a protecting group to be removed by an action of an acid, and a compound represented by the following General Formula (121). 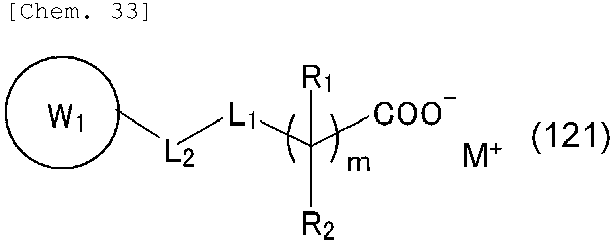
wherein, in General Formula (121), m represents an integer of 1 to 6,
R₁ and R₂ each independently represent a fluorine atom or a perfluoroalkyl group,
L₁ represents -O-, -S-, -COO-, -SO₂-, or -SO₃-,
L₂ represents an alkylene group which may have a substituent, or a single bond,
W₁ represents a cyclic organic group which may have a substituent, and
M⁺ represents a cation.

A radiation-sensitive resin composition that contains a polymer having a first structural unit represented by the following Formula (31) and a second structural unit represented by the following Formula (32) and containing an acid-dissociable group, and that contains an acid generator. 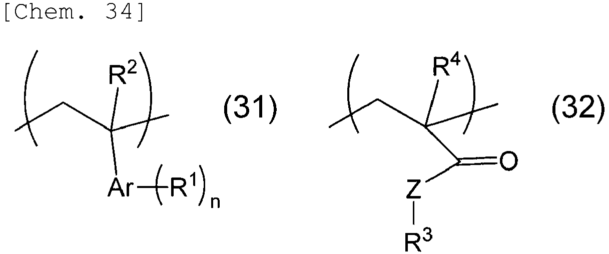 wherein, in Formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group, wherein, in Formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains a resin (A1) including a structural unit having a cyclic carbonate structure, a structural unit represented by the following formula, and a structural unit having an acid-unstable group, and that contains an acid generator. 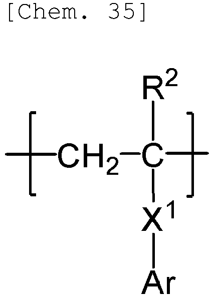 wherein, in the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bonding site with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.

Examples of the resist film include the following.

A resist film including a base resin including a repeating unit represented by the following Formula (a1) and/or a repeating unit represented by the following Formula (a2), and a repeating unit that generates an acid bonded to a polymer main chain by exposure. 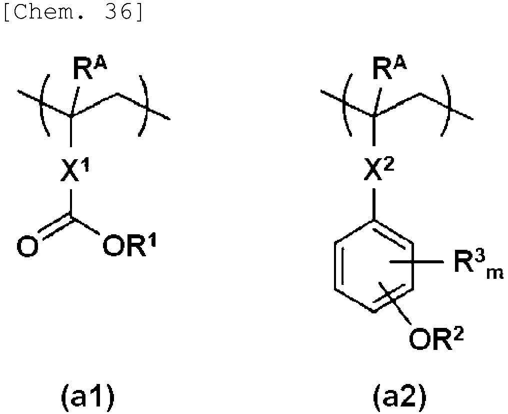 wherein, in Formulae (a1) and (a2), R^{A}'s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material include the following.

A resist material containing a polymer having a repeating unit represented by the following Formula (b1) or (b2). 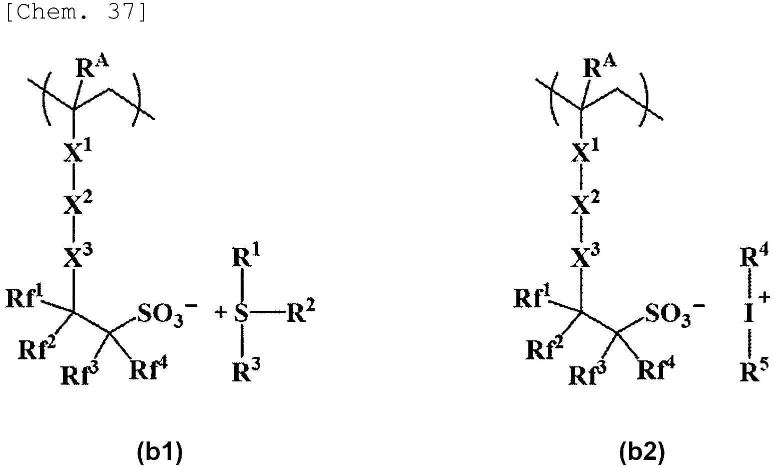 wherein, in Formulae (b1) and (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group are optionally substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxyl group, a halogen atom, an oxo group, a cyano group, an amide group, a nitro group, a sultone group, a sulfone group, or a sulfonium salt-containing group, and some of methylene groups included in these groups are optionally substituted with an ether group, an ester group, a carbonyl group, a carbonate group, or a sulfonic acid ester group, and R¹ and R² may be bonded to form a ring together with a sulfur atom to which R¹ and R² are bonded.

A resist material containing a base resin including a polymer having a repeating unit represented by the following Formula (a). 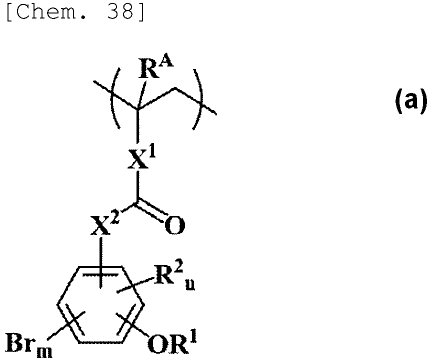 wherein, in Formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, -O-CH₂-, or -NH-, m is an integer of 1 to 4, and u is an integer of 0 to 3, provided that m + u is an integer of 1 to 4.

A resist composition generating an acid by exposure and having solubility in a developer changed by an action of an acid, the resist composition containing
a base material component (A) that has a solubility in a developer changed by an action of an acid, and a fluorine additive component (F) that exhibits decomposability in an alkaline developer,
in which the fluorine additive component (F) contains a fluororesin component (F1) that has a constituent unit (f1) containing a base-dissociable group and a constituent unit (f2) containing a group represented by the following General Formula (f2-r-1). 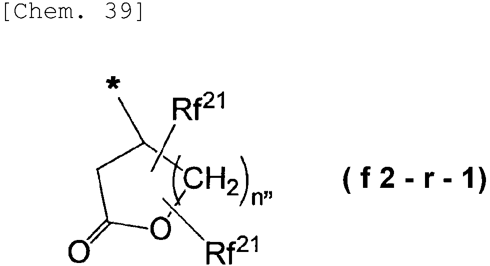
wherein, in Formula (f2-r-1), Rf²¹'s are each independently a hydrogen atom, an alkyl group, an alkoxy group, a hydroxy group, a hydroxyalkyl group, or a cyano group, n" is an integer of 0 to 2, and * is a bonding site.

The constituent unit (f1) includes a constituent unit represented by the following General Formula (f1-1) or a constituent unit represented by the following General Formula (f1-2). 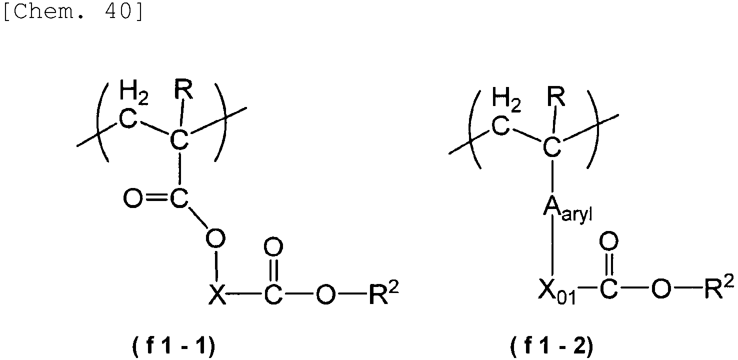 wherein, in Formulae (f1-1) and (f1-2), R's are each independently a hydrogen atom, an alkyl group having 1 to 5 carbon atoms, or a haloalkyl group having 1 to 5 carbon atoms, X is a divalent linking group not having an acid-dissociable site, A_{aryl} is a divalent aromatic ring group which may have a substituent, X₀₁ is a single bond or a divalent linking group, and R²'s are each independently an organic group having a fluorine atom.

Irradiation with light is performed, for example, through a mask (reticle) for formation of a predetermined pattern. For example, an i-line (365 nm), a KrF excimer laser (248 nm), or an ArF excimer laser (193 nm) is used. The resist underlayer film-forming composition of the present invention is preferably applied for irradiation with a KrF excimer laser (248 nm) or an ArF excimer laser (193 nm), and more preferably applied for irradiation with an ArF excimer laser (193 nm).

The exposure amount of light is not particularly limited.

Post exposure bake (PEB) may be performed after irradiation with light and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

Subsequently, the resist underlayer film is etched using the formed resist pattern as a mask. The etching may be dry etching or wet etching, but is preferably dry etching.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Hereinafter, the present invention will be more specifically described with reference to Examples, but the present invention is not limited to the following Examples. The apparatus used is as follows.

The weight average molecular weight of the polymer shown in the following examples is a measurement result obtained by gel permeation chromatography (hereinafter, abbreviated as GPC). For the measurement, a GPC apparatus manufactured by Tosoh Corporation was used, and measurement conditions and the like are as follows.
Column temperature: 40°C
Flow rate: 0.35 ml/min
Eluent: tetrahydrofuran (THF)
Standard sample: polystyrene (manufactured by Tosoh Corporation)

### <Synthesis Example 1>

A reaction flask was charged with a mixture prepared by addition of 20.00 g of a propylene glycol monomethyl ether solution of 1,6-bis(2,3-epoxypropane-1-yloxy)naphthalene (manufactured by DIC Corporation, trade name: WR-400), 1.27 g of isophthalic acid (manufactured by Tokyo Chemical Industry Co., Ltd.), 0.09 g of tetrabutylsulfonium bromide (manufactured by HOKKO CHEMICAL INDUSTRY CO., LTD.), and 1.05 g of propylene glycol monomethyl ether, and heated and stirred under a nitrogen atmosphere at 105°C for 24 hours. The obtained reaction product corresponded to Formula (X1), and the weight average molecular weight Mw thereof measured in terms of polystyrene by GPC was 7300.

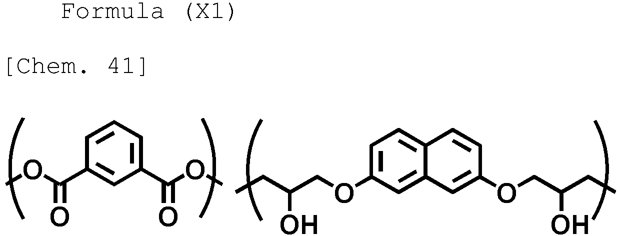

### <Synthesis Example 2>

A reaction flask was charged with a mixture prepared by addition of 2.00 g of resorcinol diglycidyl ether (product name: DENACOL EX-201-IM, manufactured by Nagase ChemteX Corporation), 1.44 g of isophthalic acid (manufactured by Tokyo Chemical Industry Co., Ltd.), 0.11 g of tetrabutylsulfonium bromide (manufactured by HOKKO CHEMICAL INDUSTRY CO., LTD.), and 20.12 g of propylene glycol monomethyl ether, and heated and stirred under a nitrogen atmosphere at 105°C for 24 hours. The obtained reaction product corresponded to Formula (X2), and the weight average molecular weight Mw thereof measured in terms of polystyrene by GPC was 9100.

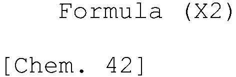

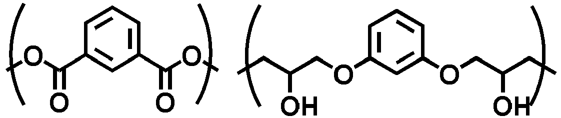

### <Synthesis Example 3>

A reaction flask was charged with a mixture prepared by addition of 15.00 g of a propylene glycol monomethyl ether solution of 1,6-bis(2,3-epoxypropane-1-yloxy)naphthalene (manufactured by DIC Corporation, trade name: WR-400), 5.65 g of resorcinol diglycidyl ether (product name: DENACOL EX-201-IM, manufactured by Nagase ChemteX Corporation), 1.31 g of isophthalic acid (manufactured by Tokyo Chemical Industry Co., Ltd.), 0.10 g of tetrabutylsulfonium bromide (manufactured by HOKKO CHEMICAL INDUSTRY CO., LTD.), and 1.39 g of propylene glycol monomethyl ether, and heated and stirred under a nitrogen atmosphere at 105°C for 24 hours. The obtained reaction product corresponded to Formula (X3), and the weight average molecular weight Mw thereof measured in terms of polystyrene by GPC was 6600.

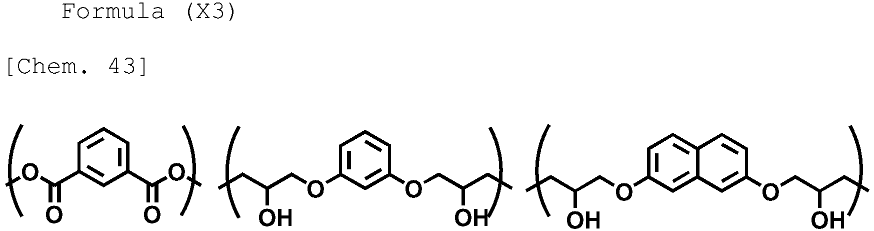

### <Synthesis Example 4>

A reaction flask was charged with a mixture prepared by addition of 3.00 g of 1,4-dihydroanthracene-9,10-diylbis(glycidyl ether) (product name: YX8800, manufactured by Mitsubishi Chemical Corporation), 3.61 g of isophthalic acid (manufactured by Tokyo Chemical Industry Co., Ltd.), 0.39 g of tetrabutylsulfonium bromide (manufactured by HOKKO CHEMICAL INDUSTRY CO., LTD.), and 38.17 g of propylene glycol monomethyl ether, and heated and stirred under a nitrogen atmosphere at 105°C for 24 hours. The obtained reaction product corresponded to Formula (X4), and the weight average molecular weight Mw thereof measured in terms of polystyrene by GPC was 6500.

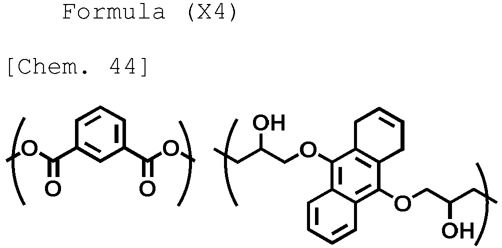

### <Synthesis Example 5>

A reaction flask was charged with a mixture prepared by addition of 40.00 g of a propylene glycol monomethyl ether solution of 1,6-bis(2,3-epoxypropane-1-yloxy)naphthalene (manufactured by DIC Corporation, trade name: WR-400), 2.18 g of isophthalic acid (manufactured by Tokyo Chemical Industry Co., Ltd.), 0.32 g of 9-anthracene carboxylic acid, 0.18 g of tetrabutylsulfonium bromide (manufactured by HOKKO CHEMICAL INDUSTRY CO., LTD.), and 2.06 g of propylene glycol monomethyl ether, and heated and stirred under a nitrogen atmosphere at 105°C for 24 hours. The obtained reaction product corresponded to Formula (X5), and the weight average molecular weight Mw thereof measured in terms of polystyrene by GPC was 7300.

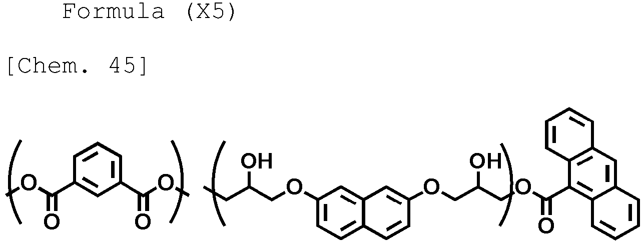

### <Comparative Synthesis Example 1>

A reaction flask was charged with a mixture prepared by addition of 10.00 g of monoallyl diglycidyl isocyanuric acid (product name: MA-DGICA, manufactured by Shikoku Chemicals Corporation), 8.96 g of 3,3'-dithiopropionic acid, 0.66 g of ethyltriphenylphosphonium bromide, and 78.47 g of propylene glycol monomethyl ether, and heated and stirred under a nitrogen atmosphere at 100°C for 23 hours. The obtained reaction product corresponded to Formula (X6), and the weight average molecular weight Mw thereof measured in terms of polystyrene by GPC was 2800.

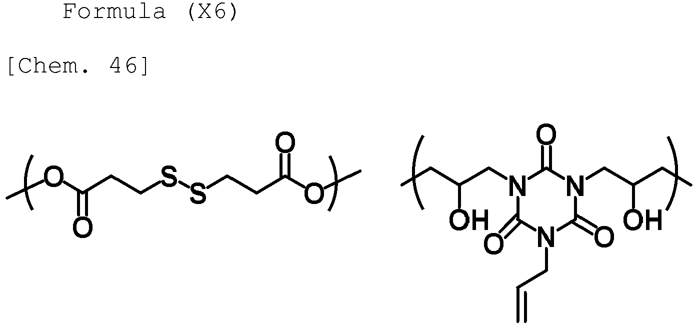

### (Example 1)

To 11.53 g of a solution containing the polymer obtained in Synthesis Example 1 (solid content concentration: 15.12 mass%), 0.17 g of tetramethoxymethyl glycoluril (trade name: POWDERLINK [registered trademark] 1174, manufactured by Nihon Cytec Industries Inc.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.42 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 2)

To 10.60 g of a solution containing the polymer obtained in Synthesis Example 1 (solid content concentration: 15.12 mass%), 0.16 g of tetramethoxymethyl glycoluril (trade name: POWDERLINK [registered trademark] 1174, manufactured by Nihon Cytec Industries Inc.) as a crosslinking agent, 0.06 g of pyridinium-p-toluenesulfonate as a crosslinking catalyst, 0.17 g of VP-2500 (manufactured by Nippon Soda Co., Ltd.) as an additive, and 0.002 g of a fluorine-based surfactant (product name: MEGAFACE R-40, manufactured by DIC Corporation) as a surfactant were mixed. The obtained mixture was dissolved in 79.20 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 3)

To 11.53 g of a solution containing the polymer obtained in Synthesis Example 1 (solid content concentration: 15.12 mass%), 0.17 g of Nikalac (registered trademark) MW-390 (manufactured by SANWA CHEMICAL CO., LTD.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.42 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 4)

To 10.60 g of a solution containing the polymer obtained in Synthesis Example 1 (solid content concentration: 15.12 mass%), 0.16 g of Nikalac (registered trademark) MW-390 (manufactured by SANWA CHEMICAL CO., LTD.) as a crosslinking agent, 0.06 g of pyridinium-p-toluenesulfonate as a crosslinking catalyst, 0.17 g of VP-2500 (manufactured by Nippon Soda Co., Ltd.) as an additive, and 0.002 g of a fluorine-based surfactant (product name: MEGAFACE R-40, manufactured by DIC Corporation) as a surfactant were mixed. The obtained mixture was dissolved in 79.20 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 5)

To 11.53 g of a solution containing the polymer obtained in Synthesis Example 1 (solid content concentration: 15.12 mass%), 0.17 g of 3,3',5,5'-tetrakis(methoxymethyl)-4,4'-dihydroxybiphenyl (product name: TMOM-BP, manufactured by Honshu Chemical Industry Co., Ltd.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.42 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 6)

To 12.18 g of a solution containing the polymer obtained in Synthesis Example 2 (solid content concentration: 14.31 mass%), 0.17 g of tetramethoxymethyl glycoluril (trade name: POWDERLINK [registered trademark] 1174, manufactured by Nihon Cytec Industries Inc.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.75 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 7)

To 11.91 g of a solution containing the polymer obtained in Synthesis Example 3 (solid content concentration: 15.57 mass%), 0.17 g of tetramethoxymethyl glycoluril (trade name: POWDERLINK [registered trademark] 1174, manufactured by Nihon Cytec Industries Inc.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.42 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 8)

To 11.91 g of a solution containing the polymer obtained in Synthesis Example 3 (solid content concentration: 15.57 mass%), 0.17 g of Nikalac (registered trademark) MW-390 (manufactured by SANWA CHEMICAL CO., LTD.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.42 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 9)

To 11.60 g of a solution containing the polymer obtained in Synthesis Example 4 (solid content concentration: 15.02 mass%), 0.17 g of 3,3',5,5'-tetrakis(methoxymethyl)-4,4'-dihydroxybiphenyl (product name: TMOM-BP, manufactured by Honshu Chemical Industry Co., Ltd.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.34 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Example 10)

To 11.91 g of a solution containing the polymer obtained in Synthesis Example 5 (solid content concentration: 14.64 mass%), 0.17 g of 3,3',5,5'-tetrakis(methoxymethyl)-4,4'-dihydroxybiphenyl (product name: TMOM-BP, manufactured by Honshu Chemical Industry Co., Ltd.) as a crosslinking agent, 0.06 g of pyridinium-p-toluenesulfonate as a crosslinking catalyst, and 0.002 g of a fluorine-based surfactant (product name: MEGAFACE R-40, manufactured by DIC Corporation) as a surfactant were mixed. The obtained mixture was dissolved in 78.04 g of propylene glycol monomethyl ether and 9.80 g of propylene glycol monomethyl ether acetate to prepare a solution. Thereafter, the solution was filtered using a polyethylene microfilter having a pore size of 0.05 µm to prepare a resist underlayer film-forming composition.

### (Comparative Example 1)

To 4.11 g of a solution containing the polymer obtained in Comparative Synthesis Example 1 (solid content concentration: 17.76 mass%), 0.18 g of tetramethoxymethyl glycoluril (trade name: POWDERLINK [registered trademark] 1174, manufactured by Nihon Cytec Industries Inc.) as a crosslinking agent, 0.06 g of 4-hydroxybenzenesulfonic acid as a crosslinking catalyst, 0.01 g of bis(4-hydroxyphenyl)sulfone as an additive, and 0.007 g of a fluorine-based surfactant (product name: MEGAFACE R-40, manufactured by DIC Corporation) as a surfactant were mixed. The obtained mixture was dissolved in 85.76 g of propylene glycol monomethyl ether and 9.91 g of propylene glycol monomethyl ether acetate to prepare a solution. Thereafter, the solution was filtered using a polyethylene microfilter having a pore size of 0.05 µm to prepare a resist underlayer film-forming composition.

### [Resist Solvent Resistance Test]

Each of the resist underlayer film-forming compositions prepared in Examples 1 to 10 and Comparative Example 1 was applied (used in spin-coating) onto a silicon wafer with a spin coater. The silicon wafer after the application was heated on a hot plate at 215°C for 1 minute to form a resist underlayer film. Next, for confirming the resist solvent resistance of the resist underlayer film, the silicon wafer after formation of the resist underlayer film was immersed for 1 minute in a solvent in which propylene glycol monomethyl ether (PGME) and propylene glycol monomethyl ether acetate (PGMEA) were mixed at a weight ratio of 7 : 3 (PGME : PGMEA = 7 : 3), spin-dried, and then baked at 100°C for 30 seconds. The film thickness of the resist underlayer film before and after immersion in the mixed solvent was measured with an optical interference film thickness meter (product name: NanoSpec 6100, manufactured by Nanometrics Japan Ltd.).

From the following calculation formula, the resist solvent resistance was evaluated by calculating the resist underlayer film thickness reduction rate (%) resulting from removal by solvent immersion. The results are shown in Table 1. When the film thickness reduction rate is about 2% or less, the film had sufficient resist solvent resistance, and was evaluated as "good". The results are shown in Table 1. $Film thickness reduction rate \left(%\right) = \left[\left(A-B\right)\div A\right] \times 100$
- A:: Film thickness before solvent immersion
- B:: Film thickness after solvent immersion

**[Table 1]**

| | Solvent resistance |
|---|---|
| Example 1 | Good |
| Example 2 | Good |
| Example 3 | Good |
| Example 4 | Good |
| Example 5 | Good |
| Example 6 | Good |
| Example 7 | Good |
| Example 8 | Good |
| Example 9 | Good |
| Example 10 | Good |
| Comparative Example 1 | Good |

### [Measurement of Optical Constant]

Each of the resist underlayer film-forming compositions prepared in Examples 1 to 10 and Comparative Example 1 was applied onto a silicon wafer at a rotation speed of 1500 rpm with a spinner. Baking was performed on a hot plate at 215°C for 1 minute to form a resist underlayer film. For these resist underlayer films, an n value (refractive index) and a k value (attenuation coefficient or extinction coefficient) at a wavelength of 193 nm were measured using a spectroscopic ellipsometer (VUV-VASE VU-302, manufactured by J.A. Woollam). The results are shown in Table 2.

**[Table 2]**

| | n/k @193 nm |
|---|---|
| Example 1 | 1.40/0.27 |
| Example 2 | 1.44/0.35 |
| Example 3 | 1.38/0.33 |
| Example 4 | 1.37/0.29 |
| Example 5 | 1.41/0.36 |
| Example 6 | 1.34/0.49 |
| Example 7 | 1.35/0.35 |
| Example 8 | 1.38/0.31 |
| Example 9 | 1.44/0.31 |
| Example 10 | 1.40/0.31 |
| Comparative Example 1 | 1.95/0.27 |

From the results in Table 2, it is found that the resist underlayer film obtained from the resist underlayer film-forming composition of the present invention has a sufficiently low n value for light having a wavelength of 193 nm as compared with a resist underlayer film obtained from a known resist underlayer film-forming composition.

## Claims

1. A resist underlayer film-forming composition, comprising: a polymer having a unit structure represented by the following Formula (1); and a solvent: 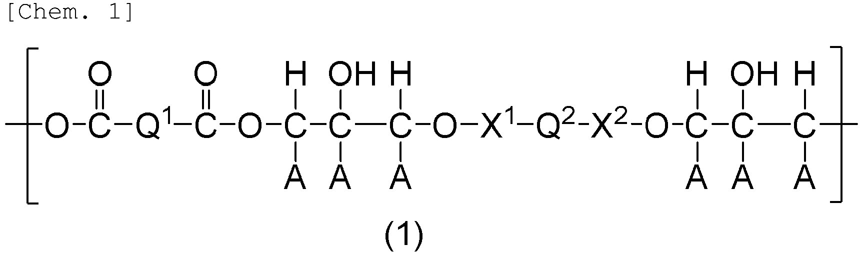 wherein, in Formula (1), A's each independently represent a hydrogen atom, a methyl group, or an ethyl group, Q¹ and Q² each independently represent a divalent group having an aromatic hydrocarbon ring, and X¹ and X² each independently represent a single bond or -C(=O)-.

2. The resist underlayer film-forming composition according to claim 1, wherein, in the above Formula (1), Q¹ is represented by the following Formula (2), and Q² is represented by any one of the following Formulae (3-1) to (3-3): 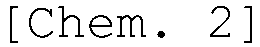 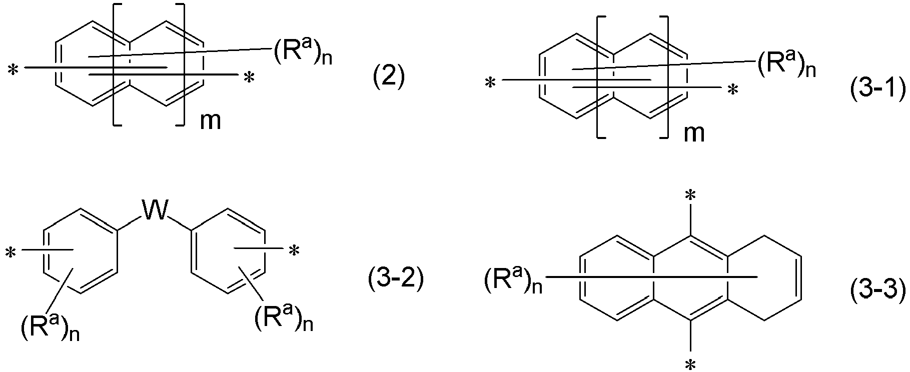
wherein, in Formula (2) and Formulae (3-1) to (3-3), R^{a}'s each independently represent an alkyl group having 1 to 10 carbon atoms, an alkoxy group having 1 to 10 carbon atoms, or an alkenyl group having 2 to 10 carbon atoms,
W represents a single bond, -CH₂-, -C(CH₃)₂-, -C(CF₃)₂-, -CO-, -O-, -S-, or SO₂-,
m's each independently represent an integer of 0 to 2,
n's each independently represent an integer of 0 to 4, and
* represents a bonding site.

3. The resist underlayer film-forming composition according to claim 1, wherein the solvent contains at least one type selected from the group consisting of an alkylene glycol monoalkyl ether and a monocarboxylic acid ester of an alkylene glycol monoalkyl ether.

4. The resist underlayer film-forming composition according to claim 1, further comprising a crosslinking agent.

5. The resist underlayer film-forming composition according to claim 1, further comprising a curing catalyst.

6. A resist underlayer film, which is a cured product of the resist underlayer film-forming composition according to any one of claims 1 to 5.

7. A laminate, comprising:
a semiconductor substrate; and
the resist underlayer film according to claim 6.

8. A semiconductor element producing method, comprising the steps of:
forming a resist underlayer film on a semiconductor substrate using the resist underlayer film-forming composition according to any one of claims 1 to 5; and
forming a resist film on the resist underlayer film.

9. A pattern forming method, comprising steps of:
forming a resist underlayer film on a semiconductor substrate using the resist underlayer film-forming composition according to any one of claims 1 to 5;
forming a resist film on the resist underlayer film;
irradiating the resist film with light, and then developing the resist film to obtain a resist pattern; and
etching the resist underlayer film using the resist pattern as a mask.
